# FASCICULE DE BREVET EUROPEEN

(11) **EP 3 182 071 B1**
(45) Date de publication et mention de la délivrance du brevet: **22.08.2018**
(21) Numéro de dépôt: 16166007.1
(22) Date de dépôt: 19.04.2016
(51) Int. Cl.: G01D 21/00, G01P 15/02, G01K 5/72, H02N 2/18

(54) **DÉTECTEUR D'ÉVÈNEMENTS**
EREIGNISDETEKTOR
EVENT DETECTOR

(30) Priorité: 15.12.2015 FR 1562409
(43) Date de publication de la demande: 21.06.2017
(73) Titulaire: STMicroelectronics (Crolles 2) SAS, 38920 Crolles (FR)
(72) Inventeur: MONFRAY, Stéphane, 38320 EYBENS (FR); MAITRE, Christophe, 38530 BARRAUX (FR); SKOTNICKI, Thomas, 38920 CROLLES-MONTFORT (FR)
(74) Mandataire: Casalonga

(56) Documents cités:
- EP-A1- 0 549 519
- EP-A2- 1 317 056
- US-A1- 2010 076 714

## Description

Des modes de réalisation de l'invention concernent les détecteurs d'évènements, par exemple les détecteurs de chaleur ou les détecteurs de choc sans que ces exemples ne soient limitatifs et plus particulièrement le détecteur d'événement autonome sans pile sans contact, en particulier basé sur un stockage d'énergie mécanique.

Un détecteur d'évènement a généralement pour but de signaler l'occurrence d'un évènement donné, tel que fumée, chaleur, mouvement, lumière ou choc etc.

Généralement, un tel détecteur d'évènement nécessite une source d'alimentation, comme par exemple des piles, pour alimenter un module électronique configuré pour générer un signal d'alarme, par exemple sonore ou/et lumineuse, en présence de l'évènement. Une gestion de la durée de vie de la source d'alimentation est par conséquent toujours nécessaire et peut être problématique. Le document EP 0 549 519 A1 décrit un détecteur d'évènement comprenant un générateur d'énergie électrique avec un élément piézoélectrique et une masse reliée à un ressort. Un déclencheur maintient la masse dans une position initiale avec le ressort tendu et, en réponse à l'évènement à détecter, le déclencheur libère la masse de façon à provoquer un battement de la masse sur l'élément piézoélectrique pour susciter une génération d'énergie électrique. Un système électronique couplé à l'élément piézoélectrique est configuré pour convertir l'énergie électrique délivrée par l'élément piézoélectrique en un signal électrique. Ainsi, selon un mode de réalisation, il est proposé un détecteur d'événement autonome sans pile basé sur un stockage d'énergie mécanique. La génération d'énergie est effectuée ponctuellement par conversion de l'énergie mécanique stockée lorsque l'évènement à détecter se produit. Le signal du détecteur est en outre délivré, par exemple de façon sans fil, à un noeud de réception connecté par exemple à un réseau d'action centralisé, par exemple un centre de sapeurs-pompiers.

Selon un aspect, il est proposé un détecteur d'évènements, comprenant
un générateur d'énergie électrique comportant un élément piézoélectrique flexible et une masse fixée sur l'élément ;
un déclencheur comportant une première configuration dans laquelle le déclencheur est configuré pour maintenir la masse dans une position initiale avec l'élément piézoélectrique fléchi et une deuxième configuration dans laquelle le déclencheur, en réponse audit événement, est configuré pour libérer la masse de façon à provoquer une vibration de l'élément piézoélectrique et permettre une génération de l'énergie électrique; et
un système électronique couplé au générateur et configuré pour convertir l'énergie électrique délivrée par le générateur en au moins un signal électrique.

Selon un mode de réalisation, l'événement à détecter est le franchissement d'une température seuil, dans un sens ou dans l'autre.

Le détecteur d'événement peut comprendre par exemple un châssis et le déclencheur peut comporter au moins une partie déformable en fonction de la température, la partie déformable étant solidaire du châssis et configurée pour être suffisamment déformée lorsque la température franchit la température seuil de façon à placer le déclencheur dans sa deuxième configuration et permettre la libération de la masse.

En outre, la partie déformable peut comprendre par exemple un bilame. Ladite température seuil peut avantageusement être déterminée par la température critique du bilame.

Un tel détecteur peut avantageusement être utilisé en tant que détecteur d'incendie.

Selon un autre mode de réalisation, l'évènement à détecter est un niveau de choc seuil sur le détecteur.

Le déclencheur peut comprendre un châssis et le déclencheur peut comprendre un élément de maintien solidaire du châssis et configuré pour maintenir la masse dans ladite position initiale et la libérer en présence d'un choc sur le châssis ayant le niveau de choc seuil.

Un tel détecteur de choc peut être largement utilisé dans des applications domotiques, automobile et de stockage de matériel, pour détecter une intrusion dans un véhicule ou dans un local.

Par ailleurs, le système électronique peut comprendre par exemple un moyen de stockage configuré pour stocker l'énergie électrique délivrée par le générateur et un circuit électronique alimenté par le moyen de stockage et configuré pour délivrer ledit au moins un signal électrique.

Le système électronique peut avantageusement comprendre une interface, par exemple une interface sans fil (Wi-Fi, NFC (« Near Field Communication » en anglais)) et du réseau internet.

Une interface sans fil permet de déplacer et d'installer facilement des détecteurs d'évènements dans des endroits souhaités.

D'autres avantages et caractéristiques de l'invention apparaîtront à l'examen de la description détaillée de modes de réalisation, nullement limitatifs, et des dessins annexés sur lesquels :

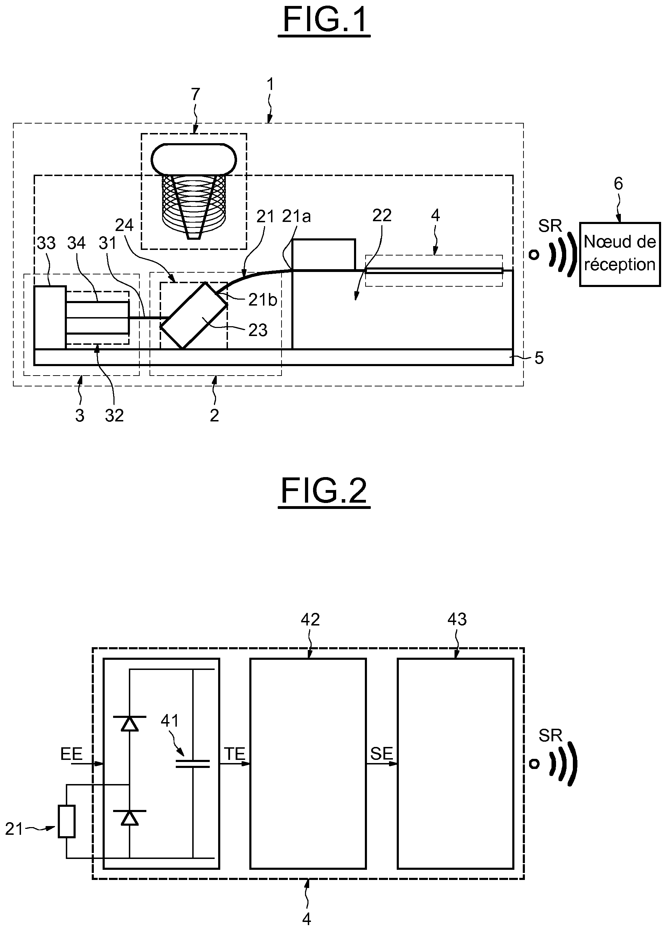

- Les figures 1 à 4 illustrent schématiquement des modes de réalisation de l'invention.

La figure 1 illustre schématiquement un détecteur d'évènement selon l'invention, ici un détecteur de chaleur 1, comprenant un générateur d'énergie électrique 2, un déclencheur flexible 3, un système électrique 4 et un châssis 5. Un noeud de réception 6 destiné à recevoir le signal d'alarme délivré par le détecteur 1 au moyen d'une connexion sans fil est également illustré sur la figure 1.

Le générateur d'énergie électrique 2 comprend un élément piézoélectrique flexible 21 dont une première extrémité 21a est solidaire d'un bloc rigide 22 fixé sur le châssis 5 et une masse oscillante 23 fixée sur une deuxième extrémité 21b suitée à l'opposé de la première extrémité 21a.

L'élément piézoélectrique 21 est déformable en torsion de façon à permettre à la masse oscillante 23 atteindre au moins une position initiale 24 dans laquelle le générateur 2 peut stocker de l'énergie sous forme mécanique, c'est-à-dire une énergie potentielle.

En outre, avec les caractéristiques intrinsèques de l'élément piézoélectrique 21, le générateur d'énergie électrique 2 permet de convertir l'énergie mécanique stockée en énergie électrique destinée à être délivrée au système électrique 4 une fois que le générateur 2 est déclenché par le déclencheur 3.

Le déclencheur 3 comporte une accroche 31 et une partie déformable 32 couplée entre une base rigide 33 fixée sur le châssis 5 et l'accroche 31.

Ici, dans le cas du détecteur de chaleur, la partie déformable 32 comprend un bilame 34 comportant deux plaques de métaux différents possédant chacun un coefficient de dilatation différent et collée l'une contre l'autre. De ce fait, le bilame 34 se déforme avec la variation de température.

Il convient de noter que la température seuil de détection du détecteur 1 est de facto fixée par la température critique du bilame 34.

Le déclencheur 3 comprend une première configuration et une deuxième configuration.

Dans la première configuration, le déclencheur 3 est configuré pour maintenir la masse oscillante 23 dans sa position initiale 24 via l'accroche 31.

Dans la deuxième configuration, le déclencheur 3 est configuré pour libérer la masse oscillante 23 à partir de la position initiale 24, lors du franchissement de la température seuil, de façon à provoquer un cycle de vibration mécanique convertible en énergie électrique par l'élément piézoélectrique 21.

Le système électronique 4 du détecteur 1 est solidaire du bloc rigide 22 et couplé électriquement à l'élément piézoélectrique 21 de façon à recevoir et utiliser l'énergie électrique convertie par le générateur d'énergie électrique 2.

Comme on le verra plus en détails ci-après, le système électronique 4 est configuré pour convertir l'énergie électrique délivrée par le générateur 2 en au moins un signal électrique SE puis, dans cet exemple, en un signal radiofréquence d'alarme SR.

Avantageusement, le signal électrique SE délivré par le système électronique 4 comprend une trame destinée à être captée par un noeud de réception externe 6 fonctionnant en permanence et connecté à un réseau d'alarme qui permet donc d'agir en réponse au déclenchement de l'alarme, incluant par exemple une alerte sur un téléphone portable, un appel pompier en précisant la position complète de la pièce d'installation du détecteur 1.

Le détecteur 1 comprend en outre un ré-amorceur 7 situé par exemple au-dessus de la masse oscillante 23 et configuré pour replacer la masse 23 à la position initiale 24 après chaque déclenchement du générateur 2.

On se réfère maintenant à la figure 2 pour illustrer un exemple de la structure interne du système électronique 4. Celui-ci comprend
un moyen de stockage 41 comportant au moins un condensateur de stockage connecté à l'élément piézoélectrique et configuré pour stocker l'énergie électrique EE délivrée par la générateur 2 ;
un circuit électronique 42 alimenté par le moyen de stockage 41 et configuré pour comparer la tension TE dudit au moins un condensateur de stockage avec une tension seuil d'entrée de façon à délivrer au moins un signal électrique d'alarme SE si la tension TE dudit au moins un condensateur est supérieure à la tension seuil d'entrée, le circuit électronique 42 peut comprendre un microcontrôleur destiné à délivrer ledit au moins un signal électrique SE qui comprend ladite trame destinée à être captée par le noeud de réception 6 ; et
une interface 43 alimentée par le circuit électronique 42 et configuré pour délivrer ledit au moins un signal électrique d'alarme SR à l'extérieur du détecteur 1.

Pour une installation plus simple et plus libre du détecteur 1, l'interface 43 est avantageusement une interface sans fil par exemple du type Wi-Fi, IEEE 802.15.14, BLE (« Bluetooth Low Energy » en anglais), etc., capable de communiquer avec le noeud de réception 6 et ainsi se connecter au réseau Internet via le noeud de réception 6. L'interface peut être également du type sans contact (NFC : « Near Field Communication » ; communication champs proche).

Le signal délivré par l'interface 43 en sortie du système électronique 4 est alors un signal radiofréquence SR. Bien entendu qu'on pourrait également utiliser une interface filaire pour délivrer le signal électrique SE d'alarme.

Il convient de noter que le circuit électronique 42 ne nécessite pas d'alimentation autre que la tension TE délivrée par ledit au moins un condensateur de stockage 41 pour son fonctionnement une fois que cette tension TE dépasse ladite tension seuil.

En outre, l'énergie électrique EE délivrée à l'issu d'un cycle de vibration mécanique de l'élément piézoélectrique 21 après un déclenchement du détecteur 1 est suffisante pour atteindre ladite tension seuil.

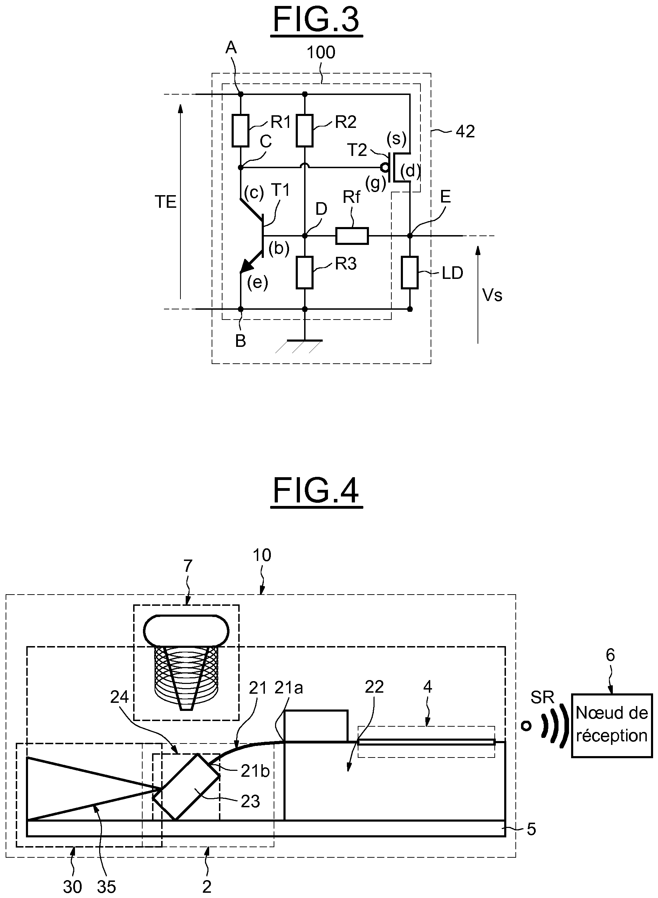

A cet effet, le circuit électronique 42 peut comprendre par exemple un circuit de comparaison d'une tension à un seuil du type de celui décrit dans la demande de brevet français FR 3 030157 A1 dont on en rappelle ici un mode de réalisation en se référant à la figure 3.

Le circuit de comparaison 100 de la figure 3 comprend une première branche comportant une résistance R1 et un transistor T1 en série entre des noeuds A et B d'application d'une tension d'entrée, ici la tension TE délivrée par ledit au moins un condensateur de stockage 41. Plus particulièrement, dans l'exemple représenté, la résistance R1 a une première extrémité reliée au noeud A et une deuxième extrémité reliée à un noeud C, et le transistor T1 à un premier noeud de conduction relié au noeud C et un deuxième noeud de conduction relié au noeud B. Dans l'exemple représenté, le transistor T1 est un transistor bipolaire de type NPN, dont le collecteur (c) est relié au noeud C et dont l'émetteur (e) est relié au noeud B.

Le circuit 100 comprend en outre une deuxième branche parallèle à la première branche, comportant deux résistances R2 et R3 en série entre les noeuds A et B. Plus particulièrement, dans l'exemple représenté, la résistance R2 a une première extrémité reliée au noeud A et une deuxième extrémité reliée à un noeud D, et la résistance R3 a une première extrémité reliée au noeud D et une deuxième extrémité reliée au noeud B. Les résistances R2 et R3 forment un pont diviseur de tension. Le noeud D, ou point milieu du pont diviseur, est relié à un noeud de commande du transistor T1, à savoir la base (b) du transistor T1 dans l'exemple représenté.

Le circuit 100 comprend en outre une troisième branche, comportant un transistor T2 en série avec un élément résistif Rf, entre le noeud A et le noeud D. Plus particulièrement, dans l'exemple représenté, la résistance Rf a une première extrémité reliée au noeud D et une deuxième extrémité reliée à un noeud E, et le transistor T2 a un premier noeud de conduction relié au noeud E et un deuxième noeud de conduction relié au noeud A. Dans l'exemple représenté, le transistor T2 est un transistor MOS à canal P dont la source (s) est reliée au noeud A et dont le drain (d) est relié au noeud E. Un noeud de commande du transistor T2, sa grille (g) dans cet exemple, est relié au noeud C.

Les noeuds E et B sont des noeuds de fourniture d'une tension de sortie Vs du circuit 100. Une charge LD à alimenter, par exemple une interface de connexion sans fil, comme ladite interface 43, est connectée entre les noeuds E et B du circuit 100.

Le fonctionnement du circuit 100 est le suivant. Lorsque la tension d'entrée TE est basse, la tension aux bornes de la résistance R3 du pont diviseur n'est pas suffisante pour mettre en conduction le transistor T1. Le transistor T1 est donc bloqué. La tension aux bornes de la résistance R1, correspondant à la tension grille-source du transistor T2 dans cet exemple, est alors sensiblement nulle. Le transistor T2 est donc bloqué. Le courant traversant la charge LD est alors sensiblement nul, et la charge LD n'est pas alimentée. La tension de sortie Vs du circuit 100 est alors approximativement nulle.

L'élément résistif Rf contribue alors à abaisser le potentiel du noeud D en le tirant vers celui du noeud E (alors sensiblement égal à celui du noeud B), et renforce donc le blocage du transistor T1.

Lorsque la tension TE augmente jusqu'à franchir un seuil V_{SH}, la tension aux bornes de la résistance R3 atteint le seuil de mise en conduction du transistor T1. Le transistor T1 devient alors passant, et un courant circule dans la branche comportant la résistance R1 et le transistor T1. La tension aux bornes de la résistance R1, ou tension source-grille du transistor T2 dans cet exemple, augmente alors jusqu'à atteindre le seuil de mise en conduction du transistor T2. Le transistor T2 devient donc lui aussi passant. La charge LD est alors alimentée, et la tension de sortie Vs du circuit 100 devient sensiblement égale à la tension d'entrée TE (à la chute de tension du transistor T2 près). L'élément résistif Rf tend alors à rehausser le potentiel du noeud D en le tirant vers celui du noeud E (alors sensiblement égal à celui du noeud A), et contribue donc au maintien à l'état passant du transistor T1.

Lorsque la tension TE redescend sous un seuil V_{SB} inférieur au seuil V_{SH} supérieur, la tension aux bornes de la résistance R3 n'est plus suffisante pour maintenir le transistor T1 à l'état passant. Le transistor T1 se bloque donc, et la tension aux bornes de la résistance R1 devient sensiblement nulle, entraînant le blocage du transistor T2. Il en résulte que la charge LD n'est plus alimentée, et la tension Vs de sortie du circuit 100 devient sensiblement nulle.

La présence de la résistance Rf, ou résistance de rétroaction, entre les noeuds D et E, confère au circuit 100 un fonctionnement à hystérésis, c'est-à-dire que son seuil V_{SH} de commutation de l'état bloqué (Vs∼0) vers l'état passant (Vs∼Ve) est supérieur au seuil de commutation V_{SB} de l'état passant vers l'état bloqué. Ceci permet d'éviter une oscillation indésirable entre le mode alimenté et le mode non alimenté de la charge LD, notamment dans le cas où la commutation de l'état bloqué vers l'état passant s'accompagne d'un fort appel de courant dans la charge LD.

On se réfère maintenant plus particulièrement à la figure 4 pour décrire un autre mode de réalisation selon l'invention dans lequel l'évènement à détecter est un niveau de choc seuil sur le détecteur de choc 10.

Le détecteur de choc 10 comprend le même générateur d'énergie électrique 2, le même système électrique 4 et le même châssis 5 que ceux du détecteur de chaleur 1 que l'on a décrit plus en détails ci-avant.

Dans cette variante, le détecteur de choc 10 comporte un déclencheur 30 comportant un élément de maintien 35 solidaire du châssis 5 et configuré pour maintenir la masse oscillante 23 du générateur 2 dans ladite position initiale 24.

La forme de l'élément de maintien 35 est spécialement conçue, par exemple sous forme de cône comme illustré sur la figure 3, de même que son positionnement sur la masse 23, pour à la fois maintenir la masse 23 et être sensible aux chocs sur le détecteur de choc 10.

Si le choc appliqué sur le détecteur de choc 10 franchit un niveau de choc seuil, l'élément de maintien 35 se déplace ou/et se déforme de façon à libérer la masse oscillante 23, pour délivrer le signal radiofréquence d'alarme SR à un noeud de réception 6, comme décrit ci-avant pour le cas du détecteur de chaleur 1.

Ainsi, on obtient par exemple un détecteur d'évènements (1, 10) autonome sans pile possédant une source d'alimentation ponctuelle basée sur un stockage d'énergie mécanique, et permettant, en réponse audit événement, de délivrer un signal électrique d'alarme SE, éventuellement un signal radiofréquence SR capté par un noeud de réception 6 et déclenchant une alerte sur un réseau connecté.

## Revendications

1. Détecteur d'au moins un événement, comprenant
un générateur d'énergie électrique (2) comportant un élément piézoélectrique (21) flexible et une masse (23) fixée sur l'élément (21) ;
un déclencheur (3) comportant une première configuration dans laquelle le déclencheur (3) est configuré pour maintenir la masse (23) dans une position initiale avec l'élément piézoélectrique (21) fléchi et une deuxième configuration dans laquelle le déclencheur (3), en réponse audit événement, est configuré pour libérer la masse (23) de façon à provoquer une vibration de l'élément piézoélectrique (21) et permettre une génération de l'énergie électrique (EE) ; et
un système électronique (4) couplé au générateur (2) et configuré pour convertir l'énergie électrique (EE) délivré par le générateur (2) en au moins un signal électrique (SE).

2. Détecteur selon la revendication 1, dans lequel l'évènement à détecter est le franchissement d'une température seuil.

3. Détecteur selon la revendication 2, dans lequel le détecteur (1) comprend un châssis (5) et le déclencheur (3) comporte au moins une partie (32) déformable en fonction de la température, la partie déformable (32) étant solidaire du châssis (5) et configurée pour être suffisamment déformée lorsque la température franchit la température seuil de façon à placer le déclencheur (3) dans sa deuxième configuration et permettre la libération de la masse(23).

4. Détecteur selon la revendication 3, dans lequel la partie (32) comprend un bilame (34).

5. Détecteur selon la revendication 1, dans lequel l'évènement à détecter est un niveau de choc seuil sur le détecteur (10).

6. Détecteur selon la revendication 5, dans lequel le déclencheur comprend un châssis (5) et le déclencheur (3) comprend un élément de maintien (35) solidaire du châssis (5) et configuré pour maintenir la masse (23) dans ladite position initiale et la libérer en présence d'un choc sur le châssis (5) ayant le niveau de choc seuil.

7. Détecteur selon l'une des revendications précédentes, dans lequel le système électronique (4) comprend un moyen de stockage (41) configuré pour stocker l'énergie électrique (EE) délivrée par le générateur (2) et un circuit électronique (42) alimenté par le moyen de stockage (41) et configuré pour délivrer ledit au moins un signal électrique (SE).

8. Détecteur selon l'une des revendications précédentes, dans lequel le système électronique (4) comprend une interface (43) configurée pour délivrer le signal électrique (SR) à l'extérieur du détecteur (1, 10).

9. Détecteur selon la revendication 8, dans lequel l'interface (43) est une interface sans fil.

## Patentansprüche

1. Detektor mindestens eines Ereignisses, umfassend:
einen Stromgenerator (2), umfassend ein biegsames piezoelektrisches Element (21) und eine auf dem Element (21) befestigte Masse (23);
einen Auslöser (3), umfassend eine erste Konfiguration, in der der Auslöser (3) eingerichtet ist, um die Masse (23) in einer Anfangsposition mit dem gebogenen piezoelektrischen Element (21) zu halten, und eine zweite Konfiguration, in der der Auslöser (3) als Antwort auf das Ereignis eingerichtet ist, um die Masse (23) freizugeben, um eine Schwingung des piezoelektrischen Elements (21) hervorzurufen und eine Erzeugung von elektrischer Energie (EE) zu ermöglichen; und
eine elektronisches System (4), das an den Generator (2) gekoppelt und eingerichtet ist, um die von dem Generator (2) gelieferte elektrische Energie (EE) in mindestens ein elektrisches Signal (SE) umzuwandeln.

2. Detektor nach Anspruch 1, bei dem das zu erfassende Ereignis die Überschreitung einer Grenztemperatur ist.

3. Detektor nach Anspruch 2, bei dem der Detektor (1) ein Gestell (5) umfasst, und der Auslöser (3) mindestens einen in Abhängigkeit von der Temperatur verformbaren Teil (32) umfasst, wobei der verformbare Teil (32) mit dem Gestell (5) verbunden und eingerichtet ist, um ausreichend verformt zu werden, wenn die Temperatur die Grenztemperatur überschreitet, um den Auslöser (3) in seiner zweiten Konfiguration anzuordnen und die Freigabe der Masse (23) zu ermöglichen.

4. Detektor nach Anspruch 3, bei dem der Teil (32) ein Bimetall (34) umfasst.

5. Detektor nach Anspruch 1, bei dem das zu erfassende Ereignis ein Grenzstoßniveau auf dem Detektor (10) ist.

6. Detektor nach Anspruch 5, bei dem der Auslöser ein Gestell (5) umfasst, und der Auslöser (3) ein mit dem Gestell (5) verbundenes Halteelement (35) umfasst, das eingerichtet ist, um die Masse (23) in der Anfangsposition zu halten und sie bei Vorhandensein eines Stoßes auf das Gestell (5), der das Grenzstoßniveau aufweist, freizugeben.

7. Detektor nach einem der vorhergehenden Ansprüche, bei dem das elektronische System (4) ein Speichermittel (41), das eingerichtet ist, um die von dem Generator (2) gelieferte elektrische Energie (EE) zu speichern, und eine elektronische Schaltung (42) umfasst, die von dem Speichermittel (41) versorgt wird und eingerichtet ist, um das mindestens eine elektrische Signal (SE) zu liefern.

8. Detektor nach einem der vorhergehenden Ansprüche, bei dem das elektronische System (4) eine Schnittstelle (43) umfasst, die eingerichtet ist, um das elektrische Signal (SR) außerhalb des Detektors (1, 10) zu liefern.

9. Detektor nach Anspruch 8, bei dem die Schnittstelle (43) eine drahtlose Schnittstelle ist.

## Claims

1. Detector of at least one event, comprising an electrical energy generator (2), including a flexible piezoelectric element (21) and a mass (23) fastened to the element (21);
a trigger (3) having a first configuration in which the trigger (3) is configured to keep the mass (23) in an initial position with the piezoelectric element (21) flexed, and a second configuration in which the trigger (3), in response to said event, is configured to release the mass (23) so as to cause a vibration of the piezoelectric element (21) and enable electrical energy (EE) to be generated; and
an electronic system (4) coupled to the generator (2) and configured to convert the electrical energy (EE) delivered by the generator (2) into at least one electrical signal (SE).

2. Detector according to Claim 1, wherein the event to be detected is the crossing of a temperature threshold.

3. Detector according to Claim 2, wherein the detector (1) comprises a chassis (5) and the trigger (3) includes at least one part (32) which is deformable as a function of the temperature, the deformable part (32) being fixed to the chassis (5) and configured to be sufficiently deformed when the temperature crosses the temperature threshold, so as to place the trigger (3) in its second configuration and enable the mass (23) to be released.

4. Detector according to Claim 3, wherein the part (32) comprises a bimetallic strip (34).

5. Detector according to Claim 1, wherein the event to be detected is a threshold shock level on the detector (10).

6. Detector according to Claim 5, wherein the trigger comprises a chassis (5), and the trigger (3) comprises a retaining element (35) fixed to the chassis (5) and configured to retain the mass (23) in said initial position and release it in the presence of a shock on the chassis (5) at the threshold shock level.

7. Detector according to any of the preceding claims, wherein the electronic system (4) comprises a storage means (41) configured to store the electrical energy (EE) delivered by the generator (2) and an electronic circuit (42) supplied by the storage means (41) and configured to deliver said at least one electrical signal (SE).

8. Detector according to any of the preceding claims, wherein the electronic system (4) comprises an interface (43) configured to deliver the electrical signal (SR) outside the detector (1, 10).

9. Detector according to Claim 8, wherein the interface (43) is a wireless interface.
